# EUROPEAN PATENT SPECIFICATION

(11) **EP 0 572 540 B1**
(45) Date of publication and mention of the grant of the patent: **20.08.1997**
(21) Application number: 92907385.6
(22) Date of filing: 24.02.1992
(51) Int. Cl.: B23Q 5/00, B23Q 1/25, F16H 19/02

(54) **ARRANGEMENT FOR DRIVING A ROTARY TOOL**
GERÄT ZUM ANTRIEB VON EINEM DREHWERKZEUG
AGENCEMENT D'ENTRAINEMENT POUR OUTILS ROTATIFS

(30) Priority: 22.02.1991 US 660149
(43) Date of publication of application: 08.12.1993
(73) Proprietor: OPTIMA INDUSTRIES, INC., Torrance, CA 90505 (US)
(72) Inventor: MARANTETTE, William, F., Torrance, CA 90503 (US)
(74) Representative: Jackson, Peter Arthur
(86) International application number: US9201442
(87) International publication number: WO9214572

(56) References cited:
- EP-A- 0 249 782
- DE-C- 973 849
- DE-C- 3 719 167
- NL-A- 8 104 631
- US-A- 2 850 338
- US-A- 2 940 322
- US-A- 3 183 730
- US-A- 3 371 558
- US-A- 3 442 160
- US-A- 3 595 096
- US-A- 3 718 050
- US-A- 4 219 293

## Description

### Background Of The Invention

Drilling machines, especially those for use in producing printed circuit boards, are confronted with demands for ever-increasing rotational speeds. Conventional drill spindles, even those of the most advanced design, have been unable to achieve rotational speeds needed for achieving desired production rates, hole quality and drill life.

The problem of drill rotation speed is especially acute for drills of smaller sizes to produce the kinds of openings increasingly required in printed circuit boards. The machines are called upon to make use of drills of 8 mils diameter and under in producing printed circuit boards. Because of the small drill diameter, the surface speed at the cutting edge is relatively low with conventional spindles. Low surface speed of the drill results in a short drill life and reduced hole quality. Production rates also suffer.

In addition to their inability to rotate drills at optimum speeds, conventional drill spindles are unable to maintain the axes of the drills in precise alignment with the path of movement of the spindle as it reciprocates in the drilling operation. For a drill of relatively large size, a slight cocking is not of major consequence. However, small drills are delicate and are easily broken as a result of even slight angularity of the drill axis relative to the direction of the movement of the spindle. Consequently, in drilling with small drills, breakage of the drills has been a major problem. In an effort to combat this, the manufacturers of drills of small diameter have manufactured the drills of metal which is not as hard as that normally used in drill production, hence being less brittle. Although this may have to a degree reduced drill breakage, it has by no means solved the problem as high rates of drill breakage continue for small drills. Moreover the less brittle material is softer and wears faster, reducing drill life.

Conventional drill spindles are complex and expensive machines. Typically, the drill spindle includes an electric motor within a housing which must be water cooled. Hence, provision is made for circulating water through the spindle assembly. An automatic collet is part of the spindle to enable drill changes to be made. The entire spindle assembly must be reciprocated vertically in order to effect drilling. This requires a large and cumbersome mechanism. The rotor of the spindle must be mounted in precision bearings requiring a long run-in period and with a limited service life.

US-A-3371558 discloses a device for imparting movement to a drill bit, the device having a single rotatable wheel which holds the bit against a bearing element. Rotation of the wheel rotates the bit, and tilting the wheel while it is rotating causes axial movement of the bit.

According to a first aspect of the present invention there is provided a device for imparting movement to a rotary tool having a cylindrical shank, the device comprising three or more rollers positioned so that the circumferential surfaces thereof collectively define an opening for receiving and engaging the shank of the rotary tool; means for rotating at least two of the rollers about axes parallel to the axis of the shank of the rotary tool, whereby, in use, the rollers frictionally rotate the rotary tool, the rollers each having axially spaced circumferential peripheries separated by an intermediate portion of lesser diameter; and means for tilting the rollers relative to the axis of the shank for causing the rollers to impart axial movement to the rotary tool.

According to a second aspect of the present invention, there is provided a method of imparting movement to a rotary tool having a cylindrical shank the method comprising the steps of arranging three or more circular rollers so that the surfaces thereof collectively define an opening for receiving the shank, the rollers having axially spaced circumferential peripheries separated by an intermediate portion of lesser diameter; positioning the cylindrical shank of the rotary tool so that the shank is engaged by the circumferential peripheries of all of the rollers; rotating the at least two rollers so that the circumferential peripheries frictionally drive the shank and impart rotational movement thereto; and tilting the rollers to impart axial movement to the rotary tool.

The present invention provides an entirely new approach to spindle design. It is capable of rotation speeds far exceeding those that can be achieved with existing machines. Rotation at 330,000 rpm is readily attainable. Drills are held in precise alignment with their path of movement so that breakage is no longer a problem, even for very small drills. The mechanism to reciprocate the spindle vertically is eliminated. Instead, the Z-axis motion is obtained by moving the drill alone instead of the spindle mechanism. The spindle is capable of drilling more holes per minute than conventional spindles. Water cooling is not needed. The spindle has a longer life and is quieter in operation than those of prior designs. Also, the spindle of this invention is simpler and can be manufactured more economically than spindles of the prior art. The spindle is more trouble-free, has a longer life, and does not require a run-in period.

No conventional collet is provided for the drill, which instead is frictionally driven by the rollers. Tilting in one direction moves the drill down and in the other retracts the drill. The axial movement is quite rapid, particularly in view of the high speeds of rotation.

The rollers are preferably driven by shafts which connect to pulleys which can be rotated by a belt. The rollers are preferably much larger in diameter than the drill shank so that rotating the rollers at a moderate speed produces a much faster rotation of the drill. The shafts for driving the rollers are preferably flexible to allow the tilt of the roller axes.

Different numbers of rollers may be employed for driving the tool. Four rollers, for example, can be positioned in an overlapping relationship so that they can be of larger diameter than is possible with three rollers that engage the tool in the same plane. This will provide greater speed multiplication to drive the tool faster. The rollers need not all be of the same diameter so long as they are rotated at speeds such that the surface speed where the tool is engaged is uniform. In order to obtain maximum torque, it is preferred that all of the rollers are driven so that they contribute to the rotational force imparted to the tool. However, where maximum torque is not essential, such as for drills of extremely small sizes, some of the rollers may be idlers.

### Brief Description Of The Drawings

Fig. 1 is a perspective view of a machine incorporating the invention;
Fig. 2 is an enlarged fragmentary perspective view of portions of the machine within the housing;
Fig. 3 is a longitudinal sectional view of the spindle arrangement;
Fig. 4 is a transverse sectional view taken along line 4-4 of Fig. 3;
Fig. 5 is a transverse sectional view taken along line 5-5 of Fig. 3;
Fig. 6 is a transverse sectional view taken along line 6-6 of Fig. 3;
Fig. 7 is a transverse sectional view taken along line 7-7 of Fig. 3;
Fig. 8 is a fragmentary elevational view illustrating the engagement of a drive roller with a tool such that the tool is rotated but axially fixed;
Fig. 9 is a fragmentary view similar to Fig. 8 but with the roller tilted to impart axial movement to the tool;
Fig. 10 is a fragmentary perspective view of the arrangement for causing vertical movement of the spindle housing;
Fig. 11 is an enlarged sectional view taken along line 11-11 of Fig. 10;
Fig. 12 is an enlarged sectional view taken along line 12-12 of Fig. 5;
Fig. 13 is an enlarged fragmentary perspective view of the flexible end portion of the roller drive shaft; and
Fig. 14 is a transverse sectional view taken along line 14-14 of Fig. 13.

### Detailed Description Of The Invention

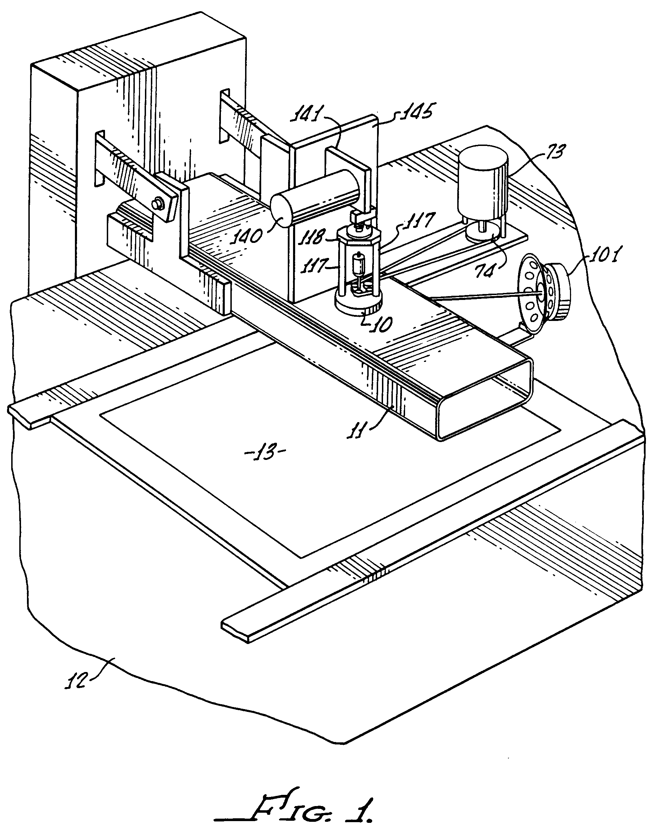

As shown in Fig. 1, the spindle of this invention includes a cylindrical housing 10 carried by a beam 11 above a table 12 upon which rests a workpiece 13 to be drilled or routed. In the embodiment illustrated, the table 12 can move horizontally in both the X and Y directions. However, it may be preferred to hold a workpiece 13 in a fixed position and move the spindle in the X and Y directions, which is particularly desirable because of the low weight and relatively small size of the spindle assembly.

Within the lower portion of the housing 10 are three circular rollers 14, 15 and 16, which may be metallic and are used to rotate and axially drive a rotary tool 17, such as a drill or router. The rollers 14, 15 and 16 are equally spaced apart angularly and collectively define an opening that receives the shank 18 of the rotary tool 17. The circumferential peripheries of all the rollers engage the shank 18 of the tool. When the rollers 14, 15 and 16 are rotated, they frictionally drive the shank 18 to rotate the tool. Because the rollers are of much larger diameter than the shank 18, the tool 17 is rotated much faster than the rollers. When three rollers are used, the tool may be rotated up to around six times as fast as the rotational speed of the rollers.

The tool 17 is moved axially by tilting the axes of the rollers 14, 15 and 16 as they rotate.

Drills and routers used in the printed circuit board industry and elsewhere all have drive shanks of a common diameter, irrespective of the size of the cutting end. Thus, the shank 18 of the drill 17 illustrated typically has a diameter of one-eighth inch, while the cutting end 19 is considerably smaller, such as a diameter of eight mils or less.

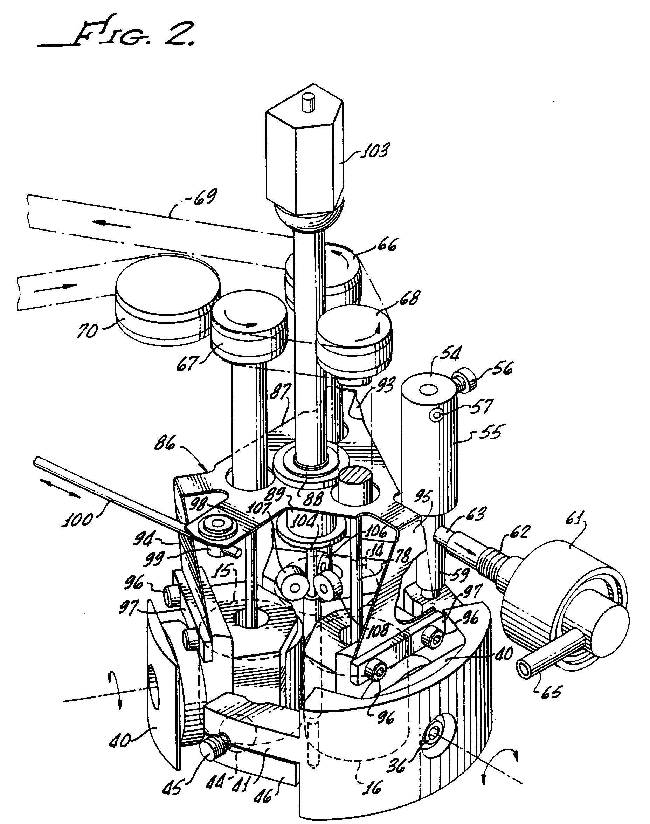

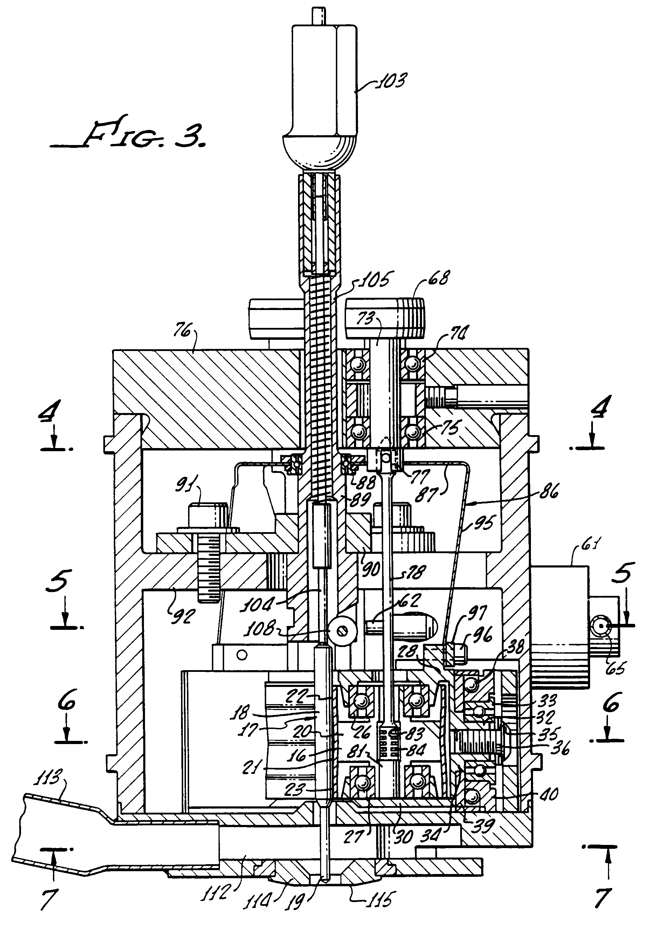

The drive rollers 14, 15 and 16 are identical and are mounted in the same way. As shown in Fig. 3, the roller 16 includes a hub portion 20 around which is a sleeve 21. The latter element includes a band 22 at its upper end and a band 23 at its lower end, which are right cylinders and are the portions of the roller which engage the shank 18 of the drill 17. Therefore, the shank 18 is engaged in two spaced planes so that it is held securely and its longitudinal axis is parallel to the axes of the rollers 14, 15 and 16 when no axial movement is imparted to the tool. The effect is the same as if the shank 18 were engaged by two spaced sets of three rollers each.

The sleeve 21 is purposely made thin so that drill shank pressure against it can deform it to provide a soft tire to compensate for minute drill shank imperfections. For example, a force of 2.3 kg (five pounds) exerted against the sleeve 21 will produce a deformation of 2.5 µm (.0001 inch).

Axially inwardly of bands 22 and 23 the sleeve 21 tapers to a smaller diameter near its center to avoid drill shank interference when the rollers are cocked to move the tool 17 axially.

The hub 20 includes axial extensions which are received within the inner races of two ball bearings 26 and 27. The outer race of the upper bearing 26 is carried by a support member 28 which extends down around most of the periphery of the roller 16. At its lower end the support member 28 is connected by screws 29 to a support plate 30 which extends beneath the roller 16, but does not engage it. Projections on the support plate 30 engage the outer race of the lower bearing 27. In this manner, the roller 16 is mounted for rotation about a vertical axis.

The support member 28 includes a lateral extension 32 that fits within the inner race of a ball bearing 33 which has its axis perpendicular to the axes of the bearings 26 and 27. At the inner edge of the bearing 33, the support member 28 provides a shoulder 34 which limits the travel of the bearing 33 inwardly toward the roller 16. The outer edge of the inner race of the bearing 33 is engaged by a Belleville washer 35 which is under the head of a screw 36 that fits within a tapped opening in the center of the extension 32 of the support member 28.

By being mounted in the ball bearing 33, the support member 28 can be rotated about an axis perpendicular to the axis of rotation of the roller 16. Such rotation will tilt the axis of rotation of the roller 16.

A thrust bearing 38 also is provided to absorb forces pushing radially outwardly on the support member 28. A flat ring 39, which has its axis concentric with the extension 32 of the support member 28, forms the inner race of the thrust bearing 38 adjacent the roller 16. The outer race of the bearing 33 is provided by a plate 40 which connects to a support. The outer surface of the plate 40 is curved in one plane and provided with openings that receive screws for attachment to the support. In the case of the roller 16, the support is a movable yoke 41 which has openings through which screws 42 extend to engage the tapped openings in the plate 40. The mounting of the yoke 41 is described below. The plates 40 for the other two rollers 14 and 15 are attached by screws to the housing 10. Thus, the positions of the rollers 14 and 15 are fixed, other than for the ability of their axes to tilt as described above.

The yoke 41 that carries the roller 16 can be pivoted so as to move the roller 16 toward or away from the two rollers 14 and 15. When pivoted toward the rollers 14 and 15, the roller 16 maintains the shank 18 of the drill 17 in engagement with the peripheries of all of the rollers so that it can be driven. When the roller 16 is moved away from the rollers 14 and 15, the drill 17 is released for removal from the rollers and replacement with a different drill.

To permit the roller 16 to be moved, one end of the yoke is mounted on a ball 44 which has a central aperture receiving a pin 45 which, exteriorly of the ball 44, is threaded into a tapped opening in the housing 10. The yoke 41 is provided with a recess that complementarily receives the ball at one end of the yoke. The bottom half of the ball 44 is confined by a similar recess in a member 46 held to the undersurface of the yoke 41 by a screw 47. A set screw 48 also is provided to allow adjustment of the clearance at the ball joint.

A ball 49 is held similarly at the opposite end of the yoke 41, confined at its lower portion by a member 50 held to the yoke by a screw 51.

The two supporting balls 44 and 49 are in a plane that bisects the roller 16 radially. This assures that the pressure of the bands 22 and 23 of the roller 16 against the drill shank 18 is nearly equal, irrespective of the skew angle of the roller or axial forces on the drill.

Pivotal movement of the yoke 41 is accomplished by a rod 52 which extends vertically of the housing and at its lower end has an extension that fits within the ball 49. The upper end 54 of the rod 52 is received within a member 55 which is attached to the housing 10 by a screw 56. A set screw 57 holds the upper end 54 in an opening in the member 55. Intermediate its upper and lower ends the rod 52 is of reduced diameter and possesses some flexibility. At its relatively large upper end 54, and at the similar lower end portion 58, the rod 52 is complementarily received within a sleeve 59.

An air cylinder 61 is provided with an extension 62 that threads into an opening in the housing 10. A rod 63 is received in the extension 62 and at its outer end engages the tube 59, to which it is perpendicular. The rod 63 extends from a movable piston 64. Air can be admitted into the cylinder 61 through a line 65 to exert a force on the piston 64 and bias the rod 63 toward the tube 59. The cylinder 61 also may be vented to atmosphere so that no force is exerted on the tube 59 by the rod 63.

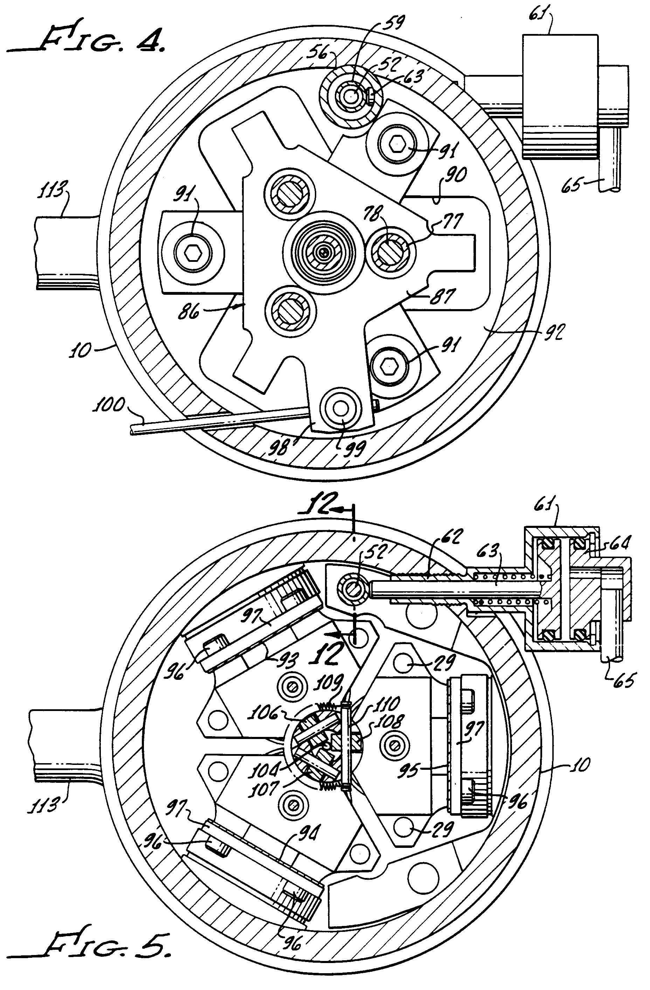

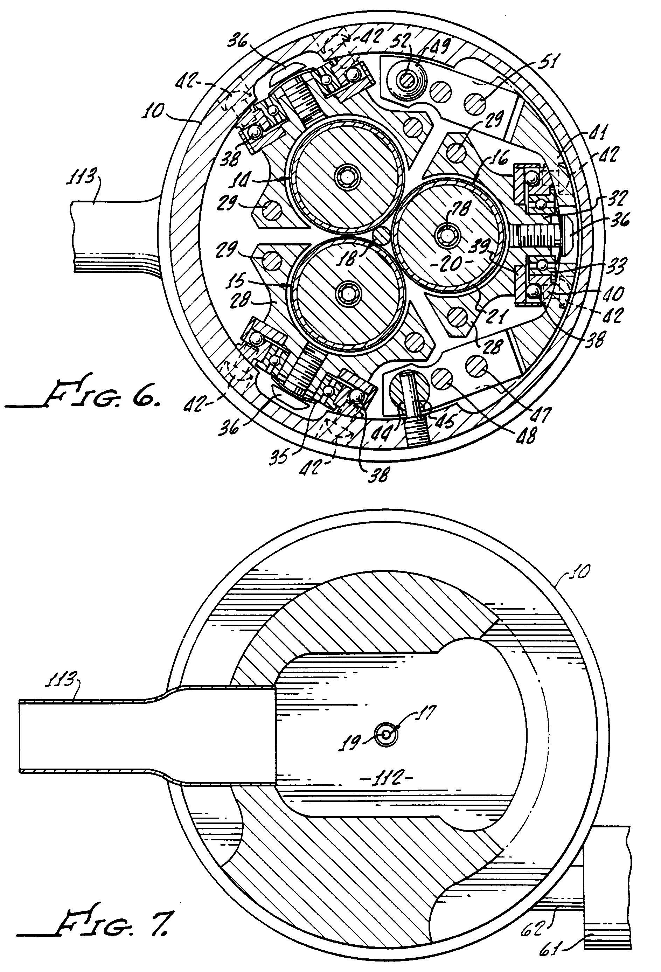

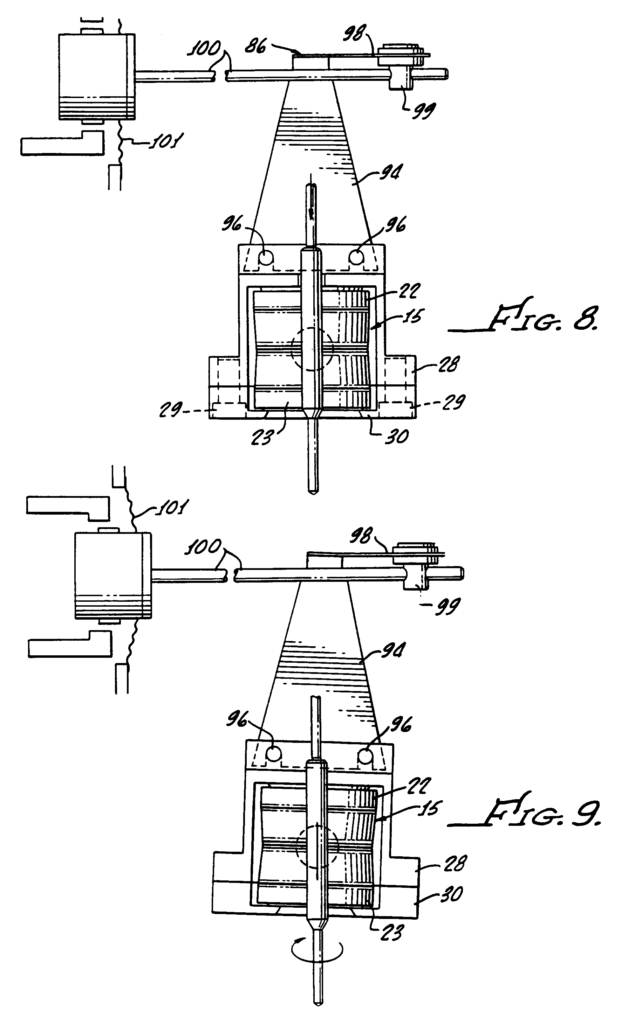

In the free position, with the air cylinder 61 vented, the rod 52 holds the yoke 41 in its outer position such that the roller 16 is separated from the rollers 14 and 15 and the drill 17 is released. This movement is very slight from the position shown in Fig. 6. When air is introduced into the cylinder 61, the force is exerted on the tube 59 by the rod 63 at a location spaced from the confined upper end 54 of the rod 52. This causes the tube 59 to bend and with it the intermediate portion of the rod 52. This deflection of the rod 52 causes the yoke 41 to be pivoted to its inner position where it forces the shank 18 of the drill 17 into engagement with the rollers 14 and 15 so that the drill then can be engaged and driven by all three of the rollers. The rod 52 is resilient so that when the air is vented from the cylinder 61 the rod acts as a spring, returning to its initial position and releasing the roller 16 from the drill 17.

The rollers 14, 15 and 16 are driven by pulleys 66, 67 and 68, respectively, which are rotated by a belt 69 that also extends around an idler pulley 70. An electric motor 71, through a drive pulley 72, drives the belt 69.

The connection between the pulley 68 and the roller 16 is shown in Fig. 3. The other pulleys 66 and 67 are connected to the rollers 14 and 15 in an identical manner. Driven by the pulley 68 is a hollow shaft 73 which is mounted in two spaced ball bearings 74 and 75 carried by the upper end wall 76 of the housing 10. The lower end 77 of the shaft 73 is slotted axially. A rod 78 fits into the lower end 77 of the hollow shaft 73 where it is rotationally driven by a cross pin 79 that extends through the slot in the shaft 73. The lower end portion 81 of the rod 78 is hollow and of enlarged diameter, fitting complementarily in an opening in the lower portion of the hub 20 within the lower ball bearing 27. This is a press fit so that the rod 78 and hub 20 and, hence, the roller 16, are locked together and rotation of the rod will rotate the roller 16.

Above the end portion 81, the rod 78 is hollow, but of very slightly reduced diameter, and positioned within an enlarged opening 83 extending axially through the hub 20. At this location the rod 78 is provided with a number of pairs of transverse slots 84 at 90 degrees to each other through its wall to form a flexible coupling section. As a result, the portion of the rod 78 within the axial center of the roller 16 has some flexibility while retaining its structural integrity and ability to impart rotation to the roller.

The axes of the rollers 14, 15 and 16 may be tilted by the actuation of a member 86 of relatively thin-walled construction which includes a flat, horizontal plate 87. This portion of the member 86 is mounted for rotation in a horizontal plane by being secured to the outer race of a ball bearing 88, as seen in Fig. 3. The inner race of the bearing 88 circumscribes a tube 89 that extends vertically through the center of the housing 10 and is carried by a horizontal member 90 which is secured by screws 91 to a transverse wall 92 within the housing. The member 86 also includes three equally spaced vertical sections 93, 94 and 95 which depend from the outer edge of the flat plate 87 and connect to the members 28 through screws 96 and attaching strips 97. Clearance is provided in the openings through the vertical sections 93, 94 and 95 for the screws 96. This allows adjustment to cause the three rollers to track equally as they are tilted to move the drill axially.

An arm 98 projects outwardly from the horizontal plate 87 and is connected by a pivot pin 99 to one end of a rod 100. This rod extends through an opening in the housing 10 and at its other end is connected to the movable cone of a permanent magnet loudspeaker 101. Electrical signals are transmitted to the speaker 101, not to produce sound, but instead to impart movement to the rod 100. It is preferred to make use of a conventional permanent magnet speaker for this purpose because it becomes a very fast acting linear servo motor and will provide the rapid increments of movement necessary for appropriately tilting the axes of the rollers 14, 15 and 16.

When the rod 100 is moved axially, it produces rotational movement of the upper plate 87 of the member 86. This, through the depending portions 93, 94 and 95 of the member 86, imposes torque on the members 28, causing them to rotate about the axes of the bearings 33. As a result, the axis of each of the rollers 14, 15 and 16 is caused to tilt in a direction perpendicular to an imaginary line, interconnecting the axis of the tool 17 and the axis of the roller. This movement is permitted because of the flexibility of the rods 78, resulting from the existence of the slots 84 through the rods at their attachments to the rollers.

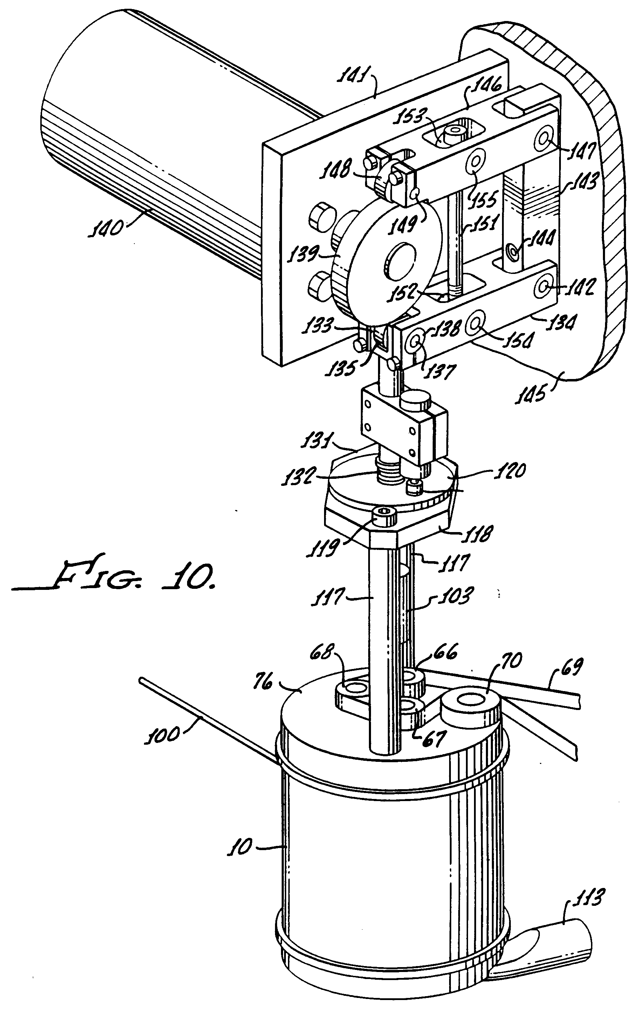

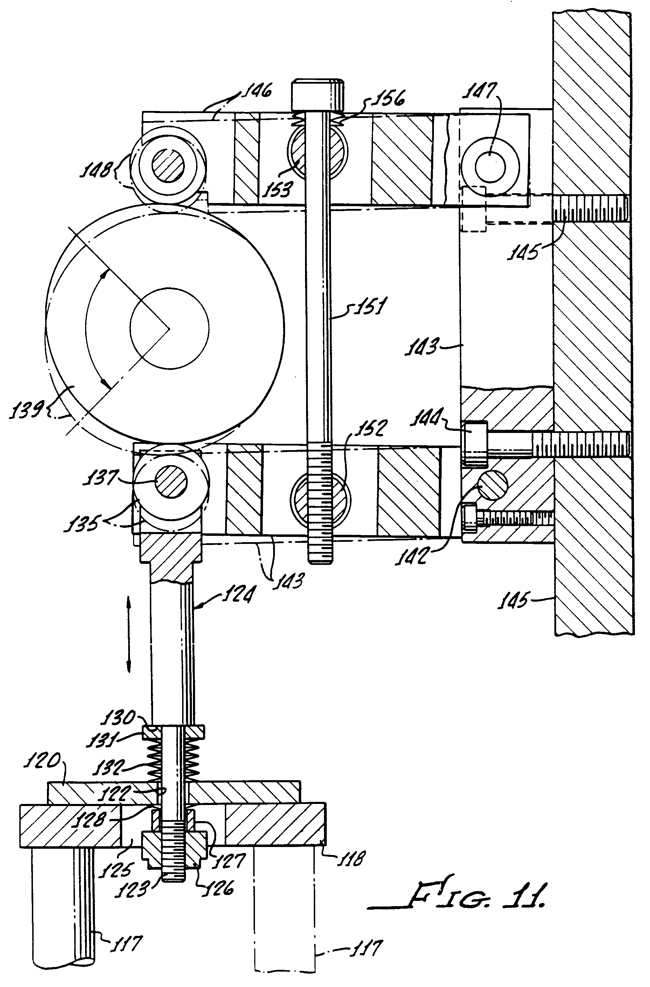

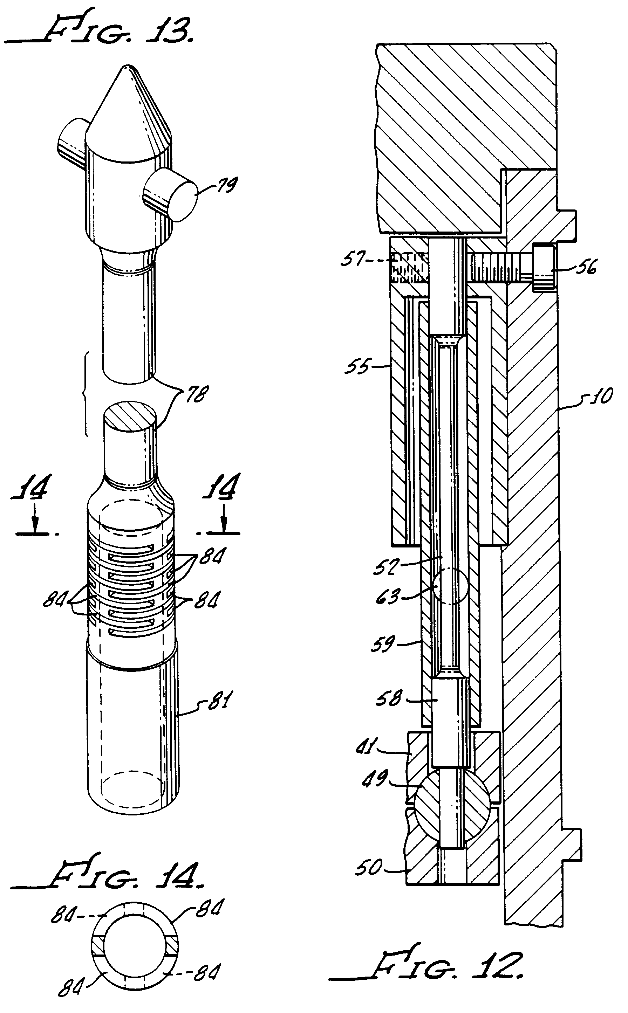

The tilting of the roller axes causes them to produce axial movement in the drill 17. This effect is illustrated in Figs. 8 and 9, where the amount of tilting of the roller axis is greatly exaggerated. In reality, very rapid axial movement of the drill 17 is accomplished by very slight tilting of the roller axes by virtue of the extremely high speeds at which the drill is rotated. Tilting in one direction will cause the drill to be driven downwardly and tilting in the opposite direction will move it upwardly. It is necessary to make slight corrective tilts of the drive rollers even at times when the tool 17 is to remain motionless axially. This is because it is not possible to achieve absolutely perfect alignment and parallelism between the roller axes and the axis of the driven tool. Any lack of such alignment will result in axial movement so that the driven tool would not remain axially fixed were it not for constant corrections of the angles of the rollers. For a machine that will drive the tool 17 at around 330,000 rpm, it is preferred to correct the roller tilt angle every one-tenth revolution.

The vertical position of the tool 17 is detected at all times so that appropriate motion may be imparted to the member 86 for controlling the tilt of the drive rollers 14, 15 and 16. To this end, the conventional position pick-off 103 is mounted above the housing, with a follower rod 104 extending downwardly through the tube 90. The lower end of the rod 104 bears against the upper end of the shank 18 of the tool 17, held in this position by a compression spring 105 within the tube 90. The rod 104, which may be segmented, does not rotate with the tool. Three rollers 106, 107 and 108, which have their axes in a horizontal plane, bear against the periphery of the lower end portion of the rod 104, keeping it aligned with the tool 17. A tension spring 109 extends around the lower portion of the tube 90 and at its ends engages the pin 110 that mounts the roller 108. This forces the roller 108 against the lower end of the rod 104 assuring that there is engagement of all three rollers 106, 107 and 108 with the rod.

The lower end portion of the housing 10 defines a chamber 112 which circumscribes the cutting end 19 of the tool 17. A vacuum line 113 connects to the chamber 112 and draws away the cuttings generated by the action of the tool 17. A collar 114 at the lower central portion of the chamber 112 has a bottom flat surface 115 which engages the workpiece and acts as a pressure foot during operation of the tool 17.

The arrangement for moving the housing 10 so that the bottom surface 115 of the collar 114 can serve as a pressure foot is shown in Figs. 10 and 11. The upper end wall 76 of the housing 10 is connected by two vertical posts 117 to a horizontal plate 118 by means of screws 119. A smaller flat horizontal plate 120 is secured by screws 121 to the upper surface of the plate 118. An opening 121 in the center of the plate 120 receives the lower end portion 123 of a vertical rod 124, this part of the rod also extending through a relatively large opening 125 in the plate 118. The bottom end of the portion 123 of the rod 124 is threaded and received within a nut 126. A collar 127 also extends around the lower portion 123 of the rod 124, as well as a Belleville washer 128 adjacent the collar that engages the undersurface of the plate 120.

Above the plate 120 the rod 124 is of increased diameter, providing a radial shoulder 130 engaged by a washer 131 that extends around the lower portion 123. A compression spring 132 extends between the washer 131 and the upper surface of the plate 120.

The upper end of the rod 124 defines a yoke 133 which is received within the slotted outer end of a generally horizontal link 134. A roller 135, which acts as a cam follower, is received within the yoke 133. An axle 137 rotationally mounts the roller 135, extending through openings in the yoke 133 and into bearings 138 in the outer end of the link 134.

Engaging the roller 135 is a cam 139 rotatable by a motor 140 secured to a support plate 141.

The inner end of the link 134 is connected by a pivot pin 142 to a vertical link 143 that is connected by screws 144 to a vertical support plate 145. The inner end of the link 134 is slotted to receive the vertical link 143.

A second horizontal link 146 is generally similar to the link 134, being of the same length. The inner end of the link 146 is slotted and, through a pivot pin 147, connects to the upper portion of the vertical link 143. The opposite end of the link 146 is slotted and receives a roller 148 which acts as a second cam follower. The roller 148 is rotatably carried by a transverse pin 149 that extends through the outer end of the link 146.

The rollers 135 and 148 are maintained in engagement with the periphery of the cam 139 by means of a vertical bolt 151 which interconnects the links 134 and 146 intermediate their ends. The bolt 151 is pivotally connected to the links 134 and 146 by means of transverse members 152 and 153, mounted in bearings 154 and 155 respectively. By tightening the bolt 151, the cam follower rollers 135 and 148 can be caused to firmly engage the surface of the cam 139 yet adjusted so that free movement of the cam is permitted. Belleville washer 156 beneath the head of the bolt facilitates the adjustment.

The cam 139 is arranged so that irrespective of its rotational position the spacing between its diametrically opposite surfaces which are engaged by the follower rollers 135 and 148 remains the same.

Vertical movement of the housing 10 is accomplished by oscillation of the cam 139. When the cam 139 is rotated a predetermined number of degrees by its motor 140, the lobe of the cam, by bearing on the roller 135, forces the rod 124 downwardly. This, in turn, acting through the washer 131 and the compression spring 132, reacts through the plates 121 and 119 and the connection at the rods 118 to move the housing 10 downwardly until the bottom surface 115 of the collar 114 engages the workpiece 13. The amount of downward force is determined by the compression imparted to the spring 132 through the movement of the rod 124. This force holds the workpiece 13 firmly against the table 12 during the operation of the tool 17.

Raising of the housing 10 to permit movement to the next station for operation on the workpiece 13 is accomplished by reverse rotation of the cam 139. The lobe of the cam 139 then reacts against the follower roller 148, pivoting the link 146 upwardly. By virtue of the connection by the bolt 151, the link 134 also is pivoted upwardly. This, through the connection to the yoke 133 of the rod 124, lifts the rod 124 upwardly in the vertical direction. The Belleville washer 128 then is brought into engagement with the undersurface of the plate 121 and through the collar 127 and the nut 126 lifts the plate 121 and with it the housing 10.

The control of the motor 140 includes a differential transformer 157 which is held in a fixed position vertically. A core 158 projects downwardly from the differential transformer 157 through an opening 159 in the plate 120. A nut 160 is threaded onto the projecting end of the core 158 above the plate 120 and another nut 161 is threaded onto the core 158 below the plate 120. Belleville washers 162 are positioned between the nut 160 and the plate 120 and similar Belleville washers 163 are between the nut 161 and the plate 120. When the plate 120 is moved downwardly by the rotation of the cam 139 imparted by the motor 140, the core 158 also is moved downwardly. This produces an output signal from the differential transformer 157 which is used in the control of the motor. When the core 158 returns to the upper position, the differential transformer also indicates the upper position of the housing.

## Claims

1. A device for imparting movement to a rotary tool (17) having a cylindrical shank (18), the device comprising three or more rollers (14,15,16) positioned so that the circumferential surfaces thereof collectively define an opening for receiving and engaging the shank of the rotary tool; means (66-72) for rotating at least two of the rollers about axes parallel to the axis of the shank of the rotary tool, whereby, in use, the rollers frictionally rotate the rotary tool, the rollers each having axially spaced circumferential peripheries separated by an intermediate portion of lesser diameter; and means (100,86) for tilting the rollers relative to the axis of the shank for causing the rollers to impart axial movement to the rotary tool.

2. A device according to claim 1, wherein there are three rollers (14,15,16), all of the same diameter.

3. A device according to claim 2, including means for moving one of the rollers (16) laterally away from the other two rollers (14,15) so as to enlarge the opening for permitting removal and insertion of the rotary tool (17) in the opening, and means for moving the one roller laterally towards the other two rollers for engaging the shank (18) for rotating the rotary tool.

4. A device according to any one of the preceding claims, including bearing means (26,27) for rotatably mounting each of the rollers (14,15,16) for rotation about its axis, a support (28) for each of the bearing means, and an additional bearing means (33) for each of the supports for rotating each of the supports about an axis perpendicular to the axis of the first bearing means of each of the rollers, the axes of the additional bearing means intersecting at a location coincident with the axis of the rotary tool (17) when the peripheries of the rollers engage the rotary tool.

5. A device according to any one of the preceding claims, wherein for rotating the rollers (14,15,16) a shaft (73) projects from each of the rollers, and including means (66,67,68) for rotating the shafts and thereby the rollers, each of the shafts being flexible so that the shafts become bent when the rollers are tilted.

6. A device according to claim 5, wherein a fixed bearing (74,75) is provided for mounting each of the shafts (73) at a location remote from the roller associated with the same.

7. A device according to claim 5 or claim 6, wherein each of the shafts (73) includes a hollow portion and is provided with a plurality of slots (84) through the hollow portion for thereby imparting flexibility to the shaft at the hollow portion.

8. A device according to any one of the preceding claims, further including means (103) for sensing the axial position of the rotary tool (17), and means for controlling the amount of tilting of the rollers (14,15,16) to position the rotary tool in a desired axial location.

9. A device according to any one of the preceding claims, wherein the means (100,86) for tilting the axes of the rollers (14,15,16) is arranged to tilt each roller axis in a direction perpendicular to a line interconnecting the axis of the shank (18) and the axis of the roller.

10. A device according to any one of the preceding claims, further including means (114) surrounding the rotary tool (17) for defining a pressure foot, and including means for reciprocating the pressure foot so that the pressure foot can engage a workpiece at the time the rotary tool engages the workpiece.

11. A method of imparting movement to a rotary tool (17) having a cylindrical shank (18), the method comprising the steps of arranging three or more circular rollers (14,15,16) so that the surfaces thereof collectively define an opening for receiving the shank, the rollers having axially spaced circumferential peripheries separated by an intermediate portion of lesser diameter; positioning the cylindrical shank of the rotary tool so that the shank is engaged by the circumferential peripheries of all of the rollers; rotating the at least two rollers so that the circumferential peripheries frictionally drive the shank and impart rotational movement thereto; and tilting the rollers to impart axial movement to the rotary tool.

12. A method according to claim 11, wherein the rollers (14,15,16) are tilted in one direction for imparting axial movement to the tool (17) in one direction and are tilted in the opposite direction for imparting axial movement to the tool in the opposite direction.

13. A method according to claim 11 or claim 12, wherein for engaging the shank (18) of a rotary tool (13), two of the rollers (14,15) are maintained in a fixed spaced relationship relative to each other, the third of the rollers (16) is moved away from the two rollers, the shank of the tool is positioned adjacent to the circumferential peripheries of the two rollers and then the third of the rollers is moved towards the other two so as to engage the shank by the circumferential periphery of the third roller and force the shank into engagement with the circumferential peripheries of the two rollers.

14. A method according to claim 13, wherein pneumatic force is applied to move the third roller (16) and is maintained on the third roller for holding the circumferential peripheries of all of the rollers (14,15,16) in engagement with the shank of the rotary tool.

15. A method according to any one of claims 11 to 14, wherein each of the rollers (14,15,16) is tilted in a direction perpendicular to a line extending between the axis of the shank (18) and the axis of the roller.

## Patentansprüche

1. Vorrichtung, um einem Umlaufwerkzeug (17), das einen zylindrischen Schaft (18) hat, eine Bewegung zu erteilen, wobei die Vorrichtung folgendes aufweist: drei oder mehr Rollen (14, 15, 16), die so positioniert sind, daß ihre Umfangsflächen gemeinsam eine Öffnung definieren, um den Schaft des Umlaufwerkzeugs aufzunehmen und damit in Eingriff zu gelangen; eine Einrichtung (66-72), um wenigstens zwei der Rollen um Achsen zu drehen, die zu der Achse des Schafts des Umlaufwerkzeugs parallel sind, so daß im Gebrauch die Rollen das Umlaufwerkzeug durch Reibung drehen, wobei die Rollen jeweils in Axialrichtung beabstandete äußere Peripherien haben, die durch einen Zwischenbereich mit kleinerem Durchmesser voneinander getrennt sind; und eine Einrichtung (100, 86), um die Rollen relativ zu der Achse des Schafts zu neigen, um die Rollen zu veranlassen, dem Umlaufwerkzeug eine axiale Bewegung zu erteilen.

2. Vorrichtung nach Anspruch 1, wobei es drei Rollen (14, 15, 16) gibt, die sämtlich gleichen Durchmesser haben.

3. Vorrichtung nach Anspruch 2, die aufweist: eine Einrichtung, um eine (16) der Rollen von den beiden übrigen Rollen (14, 15) seitlich wegzubewegen, um so die Öffnung zu vergrößern und das Entfernen und Einführen des Umlaufwerkzeugs (17) in die Öffnung zuzulassen, und eine Einrichtung zum Bewegen der einen Rolle seitlich in Richtung zu den beiden übrigen Rollen, um an dem Schaft (18) anzugreifen und das Umlaufwerkzeug zu drehen.

4. Vorrichtung nach einem der vorhergehenden Ansprüche, die aufweist: Lagereinrichtungen (26, 27) zur drehbaren Aufnahme jeder der Rollen (14, 15, 16), so daß sie um ihre jeweilige Achse drehbar ist, eine Abstützung (28) für jede der Lagereinrichtungen, und eine zusätzliche Lagereinrichtung (33) für jede der Abstützungen, um jede der Abstützungen um eine Achse zu drehen, die zu der Achse der ersten Lagereinrichtung jeder der Rollen senkrecht ist, wobei die Achsen der zusätzlichen Lagereinrichtungen einander an einer Stelle schneiden, die mit der Achse des Umlaufwerkzeugs (17) übereinstimmt, wenn die Peripherien der Rollen mit dem Umlaufwerkzeug in Eingriff sind.

5. Vorrichtung nach einem der vorhergehenden Ansprüche, wobei zum Drehen der Rollen (14, 15, 16) von jeder der Rollen eine Welle (73) vorspringt, und mit Einrichtungen (66, 67, 68), um die Wellen und dadurch die Rollen zu drehen, wobei jede der Wellen biegsam ist, so daß die Wellen gebogen werden, wenn die Rollen geneigt werden.

6. Vorrichtung nach Anspruch 5, wobei ein festes Lager (74, 75) vorgesehen ist, um jede der Wellen (73) an einer Stelle anzubringen, die von der ihr zugeordneten Rolle entfernt ist.

7. Vorrichtung nach Anspruch 5 oder Anspruch 6, wobei jede der Wellen (73) einen hohlen Bereich aufweist und mit einer Vielzahl von Schlitzen (84) durch den hohlen Bereich hindurch versehen ist, um dadurch der Welle an dem hohlen Bereich Biegsamkeit zu verleihen.

8. Vorrichtung nach einem der vorhergehenden Ansprüche, die ferner aufweist: eine Einrichtung (103) zum Erfassen der axialen Position des Umlaufwerkzeugs (17) und eine Einrichtung zum Steuern des Neigungsgrads der Rollen (14, 15, 16), um das Umlaufwerkzeug in einer gewünschten axialen Lage zu positionieren.

9. Vorrichtung nach einem der vorhergehenden Ansprüche, wobei die Einrichtung (100, 86) zum Neigen der Achsen der Rollen (14, 15, 16) angeordnet ist, um jede Rollenachse in einer Richtung zu neigen, die zu einer die Achse der Welle (18) und die Achse der Rolle schneidenden Linie senkrecht ist.

10. Vorrichtung nach einem der vorhergehenden Ansprüche, die ferner aufweist: eine Einrichtung (114), die das Umlaufwerkzeug (17) umgibt, um einen Druckfuß zu bilden, und eine Einrichtung zum Hin- und Herbewegen des Druckfußes, so daß der Druckfuß zu dem Zeitpunkt mit einem Werkstück in Eingriff gelangen kann, zu dem das Umlaufwerkzeug mit dem Werkstück in Eingriff ist.

11. Verfahren, um einem Umlaufwerkzeug (17), das einen zylindrischen Schaft (18) hat, eine Bewegung zu erteilen, wobei das Verfahren die folgenden Schritte aufweist: Anordnen von drei oder mehr kreisförmigen Rollen (14, 15, 16) so, daß ihre Oberflächen gemeinsam eine Öffnung zur Aufnahme des Schafts definieren, wobei die Rollen in Axialrichtung beabstandete äußere Peripherien haben, die durch einen Zwischenbereich mit kleinerem Durchmesser voneinander getrennt sind; Positionieren des zylindrischen Schafts des Umlaufwerkzeugs derart, daß die äußeren Peripherien sämtlicher Rollen mit dem Schaft in Eingriff gelangen; Drehen der wenigstens zwei Rollen derart, daß die äußeren Peripherien den Schaft durch Reibung antreiben und ihm eine Drehbewegung erteilen; und Neigen der Rollen, um dem Umlaufwerkzeug eine Axialbewegung zu erteilen.

12. Verfahren nach Anspruch 11, wobei die Rollen (14, 15, 16) in einer Richtung geneigt werden, um dem Umlaufwerkzeug (17) eine Axialbewegung in der einen Richtung zu erteilen, und in der Gegenrichtung geneigt werden, um dem Werkzeug in der Gegenrichtung eine Axialbewegung zu erteilen.

13. Verfahren nach Anspruch 11 oder Anspruch 12, wobei zum Eingriff mit dem Schaft (18) eines Umlaufwerkzeugs (13) zwei der Rollen (14, 15) in einer festgelegten beabstandeten Beziehung relativ zueinander gehalten werden, die dritte Rolle (16) von den beiden Rollen wegbewegt wird, der Schaft des Werkzeugs angrenzend an die äußeren Peripherien der beiden Rollen positioniert wird und dann die dritte Rolle zu den beiden anderen bewegt wird, so daß die äußere Peripherie der dritten Rolle mit dem Schaft in Eingriff gelangt und den Schaft mit den äußeren Peripherien der zwei Rollen in Eingriff drückt.

14. Verfahren nach Anspruch 13, wobei eine pneumatische Kraft aufgebracht wird, um die dritte Rolle (16) zu bewegen, und auf die dritte Rolle aufrechterhalten wird, um die äußeren Peripherien sämtlicher Rollen (14, 15, 16) in Eingriff mit dem Schaft des Umlaufwerkzeugs zu halten.

15. Verfahren nach einem der Ansprüche 11 bis 14, wobei jede der Rollen (14, 15, 16) in einer Richtung geneigt wird, die zu einer zwischen der Achse des Schafts (18) und der Achse der Rolle verlaufenden Linie senkrecht ist.

## Revendications

1. Dispositif en vue d'imprimer un mouvement à un outil rotatif (17) présentant une queue cylindrique (18), le dispositif comprenant trois galets (14, 15, 16) ou davantage disposés de telle sorte que leurs surfaces circonférentielles définissent ensemble une ouverture de réception et d'engagement de la queue de l'outil rotatif; des moyens (66-72) pour faire tourner au moins deux des galets autour d'axes parallèles à l'axe de la queue de l'outil rotatif, grâce à quoi, en utilisation, les galets font tourner l'outil rotatif par friction, les galets présentant chacun des périphéries circonférentielles axialement séparées par une partie intermédiaire de moindre diamètre; et des moyens (100, 86) pour incliner les galets par rapport à l'axe de la queue, pour amener les galets à imprimer un déplacement axial à l'outil rotatif.

2. Dispositif selon la revendication 1, qui présente trois galets (14, 15, 16), tous du même diamètre.

3. Dispositif selon la revendication 2, comprenant des moyens pour éloigner latéralement l'un des galets (16) par rapport aux deux autres galets (14, 15), de manière à agrandir l'ouverture en vue de permettre l'enlèvement et l'insertion de l'outil rotatif (17) dans l'ouverture, et des moyens pour rapprocher latéralement ce galet par rapport aux deux autres galets, pour assurer une prise sur la queue (18) et faire tourner l'outil rotatif.

4. Dispositif selon l'une quelconque des revendications précédentes, comprenant des moyens de roulement (26, 27) pour monter chacun des galets (14, 15, 16) à rotation autour de son axe, un support (28) pour chacun des moyens de roulement et un moyen de roulement supplémentaire (33) pour chacun des supports, pour faire tourner chacun des supports autour d'un axe perpendiculaire à l'axe du premier moyen de roulement de chacun des galets, les axes des moyens de roulement supplémentaires se coupant en un emplacement qui coïncide avec l'axe de l'outil rotatif (17) lorsque les périphéries des galets assurent une prise sur l'outil rotatif.

5. Dispositif selon i une quelconque des revendications précédentes, dans lequel, pour faire tourner les galets (14, 15, 16), un arbre (73) déborde de chacun des galets, et comprenant des moyens (66, 67, 68) pour faire tourner les arbres et donc les galets, chacun des arbres étant flexible de telle sorte que les arbres sont fléchis lorsque les galets sont inclinés.

6. Dispositif selon la revendication 5, dans lequel un palier fixe (74, 75) est prévu pour monter chacun des arbres (73) à un emplacement éloigné du galet associé à cet arbre.

7. Dispositif selon la revendication 5 ou la revendication 6, dans lequel chacun des arbres (73) comprend une partie creuse et est doté de plusieurs fentes (84) dans la partie creuse, pour ainsi conférer une flexibilité à l'arbre dans la partie creuse.

8. Dispositif selon l'une quelconque des revendications précédentes, comprenant en outre un moyen (103) pour détecter la position axiale de l'outil rotatif (17), et un moyen pour contrôler l'amplitude de l'inclinaison des galets (14, 15, 16), pour positionner l'outil rotatif dans une position axiale voulue.

9. Dispositif selon l'une quelconque des revendications précédentes, dans lequel les moyens (100, 86) en vue d'incliner les axes des galets (14, 15, 16) sont agencés pour incliner chaque axe de galet dans une direction perpendiculaire à une ligne reliant l'axe de la queue (18) et l'axe du galet.

10. Dispositif selon l'une quelconque des revendications précédentes, comprenant en outre un moyen (114) entourant l'outil rotatif (17) en vue de définir un pied de poussée, et comprenant un moyen pour faire se déplacer le pied de poussée en va-et-vient, de telle sorte que le pied de poussée puisse venir en prise avec une pièce au moment où l'outil rotatif entre en contact avec la pièce.

11. Procédé en vue d'imprimer un mouvement à un outil rotatif (17) présentant une queue (18), le procédé comprenant les étapes consistant à agencer trois galets circulaires (14, 15, 16) ou davantage de telle sorte que leurs surfaces définissent collectivement une ouverture pour la réception de la queue, les galets présentant des périphéries circonférentielles espacées axialement, séparées par une partie intermédiaire de moindre diamètre; à positionner la queue de l'outil rotatif de telle sorte que la queue soit serrée par les périphéries circonférentielles de chacun des galets; à faire tourner les deux galets au moins présents de telle sorte que leurs périphéries circonférentielles entraînent la queue par friction et lui impriment un mouvement de rotation; et à incliner les galets de manière à imprimer un déplacement axial à l'outil rotatif.

12. Procédé selon la revendication 11, dans lequel les galets (14, 15, 16) sont inclinés dans une direction pour imprimer à l'outil (17) un déplacement axial dans une direction, et sont inclinés dans la direction opposée pour imprimer à l'outil un déplacement axial dans la direction opposée.

13. Procédé selon la revendication 11 ou la revendication 12, dans lequel, pour assurer une prise sur la queue (18) d'un outil rotatif (13), deux des galets (14, 15) sont maintenus l'un par rapport à l'autre à un écart relatif fixe, le troisième des galets (16) est écarté des deux galets, la queue de l'outil est disposée en position contiguë aux périphéries circonférentielles des deux galets, et le troisième galet est ensuite déplacé en direction des deux autres de manière à assurer une prise sur la queue par la périphérie circonférentielle du troisième galet, et forcer la queue à venir en prise avec les périphéries circonférentielles des deux galets.

14. Procédé selon la revendication 13, dans lequel une force pneumatique est exercée pour déplacer le troisième galet (16), et est maintenue sur le troisième galet pour maintenir les périphéries circonférentielles de tous les galets (14, 15, 16) en prise avec la queue de l'outil rotatif.

15. Procédé selon l'une quelconque des revendications 11 a 14, dans lequel chacun des galets (14, 15, 16) est incliné dans une direction perpendiculaire à une ligne s'étendant entre l'axe de la queue (18) et l'axe du galet.
